# EUROPÄISCHE PATENTSCHRIFT

(11) **EP 2 149 517 B1**
(45) Veröffentlichungstag und Bekanntmachung des Hinweises auf die Patenterteilung: **05.09.2012**
(21) Anmeldenummer: 09008235.5
(22) Anmeldetag: 24.06.2009
(51) Int. Cl.: B65G 47/91

(54) **Mit Druckluft betriebener Flächensauggreifer**
Area vacuum gripper operated with pressurised air
Dispositif de préhension avec surface aspirante fonctionnant à l'air sous pression

(30) Priorität: 30.07.2008 DE 202008010424 U
(43) Veröffentlichungstag der Anmeldung: 03.02.2010
(73) Patentinhaber: J. Schmalz GmbH, 72293 Glatten (DE)
(72) Erfinder: Eisele, Thomas, 78737 Fluorn-Winzeln (DE); Schaaf, Walter, Dr., 72250 Freudenstadt-Grüntal (DE); Günther, Rolf, 72293 Glatten (DE); Stahl, Tobias, 72293 Glatten (DE)
(74) Vertreter: Steimle, Josef

(56) Entgegenhaltungen:
- FR-A1- 2 166 242
- FR-A1- 2 284 470
- JP-A- 9 002 682
- JP-A- 10 167 470
- JP-A- 2007 331 056
- US-A- 4 252 497

## Beschreibung

Die Erfindung betrifft einen mit Druckluft betriebenen Flächensauggreifer zum Greifen und gegebenenfalls Vereinzeln von Werkstücken, z.B. von dünnen, biegsamen Werkstücken.

Eine derartige Vorrichtung ist zum Beispiel aus der DE 20 2006 016 833 U1 bekannt. Bei dieser bekannten Vorrichtung handelt es sich um einen Bernoulli-Sauger mit Lochplatte, bei dem Druckluft über einen Druckluftkanal eingeblasen wird und die Druckluft über eine große Fläche in Richtung des Werkstücks austritt. Derartige Sauggreifer besitzen zwar den Vorteil, dass mit ihnen Gegenstände angesaugt werden können, jedoch dürfen diese Gegenstände nicht allzu schwer sein.

Aus der JP 9-002 682 A ist ein Sauggreifer entsprechend dem Oberbegrift von Anspruch 1 bekannt, bei welchem Druckluft über ein Röhrchen in einen Saugkanal derart eingeblasen wird, dass die Druckluft das Röhrchen im Zentrum des Saugkanals in Richtung dessen Auslasses verlässt. Bei dieser Anordnung kann die Druckluft nur wenig Luft mitreißen, d.h. nur wenig Saugluft erzeugen, da sie eine geringe Oberfläche aufweist. Aus der JP 10-167 470 A ist ein Sauggreifer bekannt, welcher nach dem Koanda-Prinzip arbeitet. Dabei strömt Druckluft schräg aus mehreren Kanälen durch die Wand eines Saugkanals in diesen ein. Auch hier ist die Saugleistung gering, da die Druckluft eine geringe Oberfläche besitzt.

Der Erfindung liegt die Aufgabe zugrunde, einen Flächensauggreifer bereitzustellen, mit dem flächige Gegenstände effektiver, z.B. zuverlässiger, definierter bzgl. der Lage, prozesssicherer oder energieeffizienter, angesaugt werden können.

Diese Aufgabe wird erfindungsgemäß mit einem Flächensauggreifer gelöst, der die Merkmale des Anspruchs 1 aufweist.

Mit dem erfindungsgemäßen Flächensauggreifer wird ein Unterdruck dadurch erzeugt, dass mit der Druckluft eine Ejektordüse betrieben wird. Diese Ejektordüse besitzt also einen Auslass, einen Saugeinlass sowie einen Drucklufteinlass. An den Saugeinlass ist die Saugkammer angeschlossen, so dass dort, wo das Werkstück anliegt, im Gegensatz zu der Vorrichtung gemäß der DE 20 2006 016 833 U1, bei der Luft in Richtung auf das Werkstück ausgeblasen wird, Luft angesaugt wird, wodurch das Werkstück sicher gehalten wird. Auf diese Weise können Wafer, Folien, Papier, das heißt dünne und auch biegsame Gegenstände schonend gegriffen und vereinzelt werden. Die Werkstücke springen dem Flächensauggreifer wegen der Sogwirkung quasi entgegen und werden vereinzelt.

Erfindungsgemäß entspricht die Richtung der Hauptluftförderung des Saugluftstroms im Anschluss der Ejektordüse an die Saugkammer der Richtung der Hauptluftförderung des Treibluftstroms in der Ejektordüse. Da der Saugluftstrom in der Ejektordüse nicht umgelenkt wird, erhält er einen hohen Geschwindigkeitsimpuls. Dies erfolgt dadurch, dass der Treibluftstrom im Anschluss der Ejektordüse an die Saugkammer in den Hauptkanal der Ejektordüse eingeleitet wird und dort sich mit dem Saugluftstrom vereint.

Erfindungsgemäß wird der Saugeinlass der Ejektordüse von der Öffnung eines hülsenförmigen Abschnitts der Ejektordüse gebildet. Dabei ist die Stirnseite des hülsenförmigen Abschnitts mit einem Abstand zur Oberfläche der Saugkammer angeordnet. Es besteht also ein Ringkanal zwischen der Öffnung des hülsenförmigen Abschnitts der Ejektordüse und der Saugkammer. Dieser Ringkanal mündet in den hülsenförmigen Abschnitt der Ejektordüse ebenso wie die Auslassöffnung der Saugkammer.

Bei einer Weiterbildung der Erfindung ist vorgesehen, dass die Saugkammer eine Auslassöffnung aufweist. Diese ist erfindungsgemäß auf der der Saugwand gegenüberliegenden Seite vorgesehen. Dabei kann die Auslassöffnung in Form einer Bohrung gebildet sein, wobei die Saugwand zum Beispiel von einem Lochblech gebildet wird.

Die Auslassöffnung der Saugkammer ist erfindungsgemäß mit dem Saugeinlass der Ejektordüse verbunden. Insbesondere fluchten diese beiden Öffnungen und liegen koaxial zueinander.

Der Saugeinlass der Ejektordüse wird von der Öffnung eines hülsenförmigen Abschnitts der Ejektordüse gebildet. Dabei ist die Stirnseite des hülsenförmigen Abschnitts mit einem Abstand zur Oberfläche der Saugkammer angeordnet. Es besteht also ein Ringkanal zwischen der Öffnung des hülsenförmigen Abschnitts der Ejektordüse und der Saugkammer. Dieser Ringkanal mündet in den hülsenförmigen Abschnitt der Ejektordüse ebenso wie die Auslassöffnung der Saugkammer.

Wie bereits erwähnt, ist der hülsenförmige Abschnitt der Ejektordüse erfindungsgemäß von einem Ringkanal umgeben, in welchen zudem der Drucklufteinlass einmündet, wobei der Ringkanal in Richtung der Saugkammer offen ist. Die Druckluft umströmt im Ringkanal den hülsenförmigen Abschnitt und tritt zwischen dessen Stirnseite und der Saugkammer ins Innere des hülsenförmigen Abschnitts ein und verlässt diesen über dessen Auslass. Dadurch wird ein Unterdruck erzeugt, über welchen Luft aus der Saugkammer abgesaugt wird.

Im Übrigen ist der Ringkanal gegenüber der Umgebung abgeschlossen. Dies bedeutet, dass ausschließlich Luft über die Saugkammer angesaugt wird.

Mit Vorzug ist die Stirnseite des hülsenförmigen Abschnitts im Bereich der Außenumfangsfläche so geformt, dass sie dort einen kleineren Übergangsradius besitzt als im Bereich der Innenumfangsfläche, wo sie einen größeren Übergangsradius aufweist. Auf diese Weise wird beim Eintritt der Druckluft in den hülsenförmigen Abschnitt die Druckluft so gelenkt, dass sie in Richtung des Auslasses strömt.

Bei einem bevorzugten Ausführungsbeispiel ist vorgesehen, dass der Ringspalt zwischen der Oberfläche der Saugkammer und der Stirnseite des hülsenförmigen Abschnitts der Ejektordüse sich radial nach innen erweitert. Diese Erweiterung bewirkt eine Geschwindigkeitsreduzierung, wodurch die Umlenkung des Druckluftstromes in Richtung des Auslasses begünstigt wird.

Ein bevorzugtes Ausführungsbeispiel sieht vor, dass sich der freie Querschnitt des hülsenförmigen Abschnitts der Ejektordüse in Richtung des Auslasses kegelförmig erweitert. Auf diese Weise wird zudem die Geschwindigkeit des Druckluftstromes reduziert, was die Saugwirkung im Bereich des freien Endes des hülsenförmigen Abschnitts der Ejektordüse erhöht.

Allgemein kann festgehalten werden, dass mit der Ejektordüse ein hülsenförmiger Betriebsluftstrom erzeugt wird, über dessen Kern Luft mitgerissen wird, wodurch ein Saugstrom in der Saugkammer erzeugt wird.

Bei einer Weiterbildung ist vorgesehen, dass insbesondere in der Saugkammer ein Vakuumsensor zur Belegkontrolle der Saugwand angeordnet ist. Ein geringes Vakuum deutet auf eine fehlende oder ungenügende Belegung der Saugwand hin, wohingegen ein großes Vakuum eine optimale Belegung der Saugwand signalisiert.

Alternativ oder zusätzlich kann in der Saugkammer ein optischer Sensor vorgesehen sein. Mit diesem optischen Sensor kann ebenfalls eine Belegkontrolle der Saugwand durchgeführt werden, wobei dieser optische Sensor auch zur Ermittlung der Werkstücklage, d.h. der Positionierung des Werkstücks verwendet werden kann.

Weitere Vorteile, Merkmale und Einzelheiten der Erfindung ergeben sich aus den Unteransprüchen sowie der nachfolgenden Beschreibung, in der unter Bezugnahme auf die Zeichnung ein besonders bevorzugtes Ausführungsbeispiel im Einzelnen beschrieben ist.

Dabei zeigen:
- Figur 1: einen Längsschnitt durch eine bevorzugte Ausführungsform eines Flächensauggreifers;
- Figur 2: eine vergrößerte Wiedergabe des Ausschnitts II gemäß Figur 1; und
- Figur 3: eine vergrößerte Wiedergabe des Ausschnitts III gemäß Figur 2.

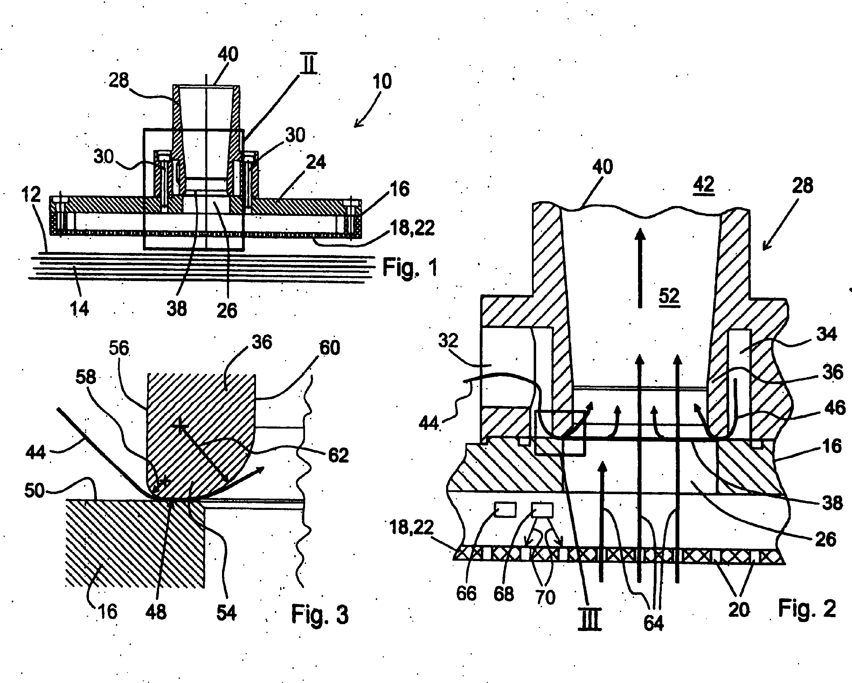

Die Figur 1 zeigt relativ schematisch einen Längsschnitt durch einen insgesamt mit 10 bezeichneten Flächensauggreifer, mit welchem ein Werkstück 12 ergriffen und angehoben werden kann. Mehrere dieser Werkstücke 12 können übereinander liegen und einen Stapel 14 bilden, so dass jeweils das oberste Werkstück 12 abgehoben werden kann. Der Flächensauggreifer 10 besitzt eine Saugkammer 16, die mit ihrer, die Unterseite bildenden Saugwand 18 auf das Werkstück 12 aufgesetzt wird. Die Vorrichtung zum Aufsetzen und Anheben des Flächensauggreifers 10, z.B. ein Roboterarm oder dergleichen, ist nicht dargestellt.

Die Saugwand 18 besitzt Durchbrüche 20 (Figur 2) und ist zum Beispiel als Lochplatte 22, insbesondere als Lochblech ausgebildet. Auf der der Saugwand 18 gegenüberliegenden Seite 24, also der Oberseite, besitzt die Saugkammer 16 eine Auslassöffnung 26, an die sich koaxial eine Ejektordüse 28 anschließt. Die Ejektordüse 28 ist zum Beispiel mittels Schrauben 30 mit der Saugkammer 16 verbunden.

Die Figur 2 zeigt eine vergrößerte Wiedergabe des Ausschnitts II gemäß Figur 1 und es ist der Anschlussbereich der Ejektordüse 28 an die Saugkammer 16 erkennbar. Die Ejektordüse 28 ist mit einem Drucklufteinlass 32 versehen, der in einen in der Ejektordüse 28 vorgesehenen Ringkanal 34 einmündet. Dieser Ringkanal 34 umgibt einen hülsenförmigen Abschnitt 36, der koaxial zur Auslassöffnung 26 der Saugkammer 16 angeordnet ist. Das freie Ende 54 des hülsenförmigen Abschnitts 36 definiert einen Saugeinlass 38, wohingegen das gegenüberliegende Ende von einem Auslass 40 gebildet wird, der ins Freie 42, d.h. in die Umgebung ausmündet. Zwischen dem Saugeinlass 38 und dem Auslass 40 erweitert sich der lichte Querschnitt des hülsenförmigen Abschnitts 36.

Ferner ist in Figur 2 mit den Pfeilen 44 und 46 andeutungsweise dargestellt, wie Druckluft über den Drucklufteinlass 32 in den Ringkanal 34 einströmt und das freie Ende 54 des hülsenförmigen Abschnitts 36 umströmt und in den Saugeinlass 38 eintritt. Dies wird dadurch ermöglicht, dass das freie Ende 54 des hülsenförmigen Abschnitts 36, wie in Figur 3 dargestellt, einen Abstand 48 zur Oberseite 50 der Saugkammer 16 aufweist, so dass die Druckluft zwischen dem hülsenförmigen Abschnitt 36 und der Oberseite 50 der Saugkammer 16 in den Saugkanal 52 des hülsenförmigen Abschnitts 36 eintreten kann. Das freie Ende 54 des hülsenförmigen Abschnitts 36 weist im Bereich der Außenumfangsfläche 56 einen kleinen Radius 58 und im Bereich der Innenumfangsfläche 60 einen großen Radius 62 auf. Der Abstand 48, insbesondere der Ringspalt zwischen dem freien Ende 54 und der Oberseite 50 der Saugkammer 16, vergrößert sich in Richtung des Saugkanals 52.

Strömt, wie mit dem Pfeil 44 angedeutet, Druckluft über den Drucklufteinlass in den Ringkanal 34 ein, dann verteilt sich diese Druckluft gleichmäßig über den Umfang des hülsenförmigen Abschnitts 36 und durchströmt den vom Abstand 48 gebildeten Ringspalt und tritt in den Saugkanal 52 als ringförmiger oder hülsenförmiger Betriebsluftstrom ein, wobei dessen Strömungsrichtung in Richtung des Auslasses 40 gerichtet ist. Dadurch wird im Kern dieses Ringstrahles Luft aus der Saugkammer 16 mitgerissen, was mit den Pfeilen 64 angedeutet ist. Diese Luft tritt durch die Durchbrüche 20 in die Saugkammer 16 ein, wodurch das Werkstück 12 an die Saugwand 18 angesaugt wird.

Innerhalb der Saugkammer 16 ist erfindungsgemäß ein Vakuumsensor 66 vorgesehen, der den Unterdruck innerhalb der Saugkammer 16 erfasst. Auf diese Weise kann ein Maß für den Belegungsgrad der Saugwand 18 ermittelt werden. Innerhalb der Saugkammer 16 ist auch ein optischer Sensor 68 angeordnet, der die Belegung der Durchbrüche 20 überwacht, was mit den Pfeilen 70 angedeutet ist. Auf diese Weise kann ebenfalls eine Belegungskontrolle durchgeführt werden, wobei aber auch die Lage, d.h. die Position des Werkstücks 12 am Flächensauggreifer 10 ermittelt werden kann.

Mit dem erfindungsgemäßen Flächensauggreifer 10 kann auf einfache und sichere Weise ein Werkstück 12 erfasst und angehoben werden.

## Patentansprüche

1. Mit Druckluft betriebener Flächensauggreifer (10) zum Greifen und gegebenenfalls Vereinzeln von Werkstücken (12), insbesondere von dünnen, biegsam Werkstücken (12), mit einer auf das Werkstück (12) aufsetzbaren Saugkammer (16), welche eine Saugwand (18) aufweist, einer einen Anschluss und einen Auslass (40) aufweisenden Ejektordüse (28), wobei die Ejektordüse (28) über ihren Anschluss an die Saugkammer (16) angeschlossen ist, und der Auslass (40) der Ejektordüse (28) ins Freie (42) oder in einen Abluftkanal ausmündet und der im Anschluss sich befindende Saugeinlass (38) der Ejektordüse (28) in die Saugkammer (16) mündet, wobei die Richtung des aus der Saugkammer (16) kommenden Luftstroms im Anschluss der Richtung der Hauptluftförderung in der Ejektordüse (28) entspricht, **dadurch gekennzeichnet, dass** die Saugwand (18) Durchbrüche (20) aufweist, und dass die Ejektordüse (28) einen hülsenförmigen Abschnitt (36) mit freiem Ende (54) aufweist, wobei das freie Ende (54) eine in Richtung des Haupt-Luftstroms gebogene oder geneigte Fläche aufweist, und die Saugkammer (16) eine Oberseite (50) aufweist, wobei ein Ringspalt (48) zwischen dem freien Ende (54) und der Oberseite (50) der Saugkammer (16) gebildet wird, wodurch die Treibluft oder Betriebluft außerhalb der Saugkammer (16) in die Ejektordüse (28) eintritt und beim Eintritt in den den Haupt-Luftförderstrom begrenzenden Raum in der Ejektordüse (28) der gebogenen oder geneigten Fläche folgt, wobei die Treibluft oder Betriebluft in die Ejektordüse (28) und in den den Haupt-Luftförderstrom begrenzenden Raum in der Ejektordüse (28) durch den Ringspalt (48) eintritt, und dass das Werkstück (12) an der die Unterseite bildenden Saugwand (18) der Saugkammer (16) anliegt.

2. Flächensauggreifer nach Anspruch 1, **dadurch gekennzeichnet, dass** der aus der Saugkammer (16) kommende Luftstrom nach dem Anschluss in der Ejektordüse (28) nicht umgelenkt wird.

3. Flächensauggreifer nach einem der vorhergehenden Ansprüche, **dadurch gekennzeichnet, dass** die Fläche durch einen um eine Achse rotierenden Radius gebildet wird.

4. Flächensauggreifer nach einem der vorhergehenden Ansprüche, **dadurch gekennzeichnet, dass** die Auslassöffnung (26) der Saugkammer (16) mit dem Saugeinlass (38) der Ejektordüse (28) verbunden ist und insbesondere koaxial zu diesem angeordnet ist.

5. Flächensauggreifer nach einem der vorhergehenden Ansprüche, **dadurch gekennzeichnet, dass** insbesondere in der Saugkammer (16) oder am Saugraum ein Sensor, z.B. ein Strömungssensor, ein Vakuumsensor (66) zur Belegkontrolle der Saugwand (18) und/oder ein optischer Sensor (68) zur Belegkontrolle und/oder Ermittlung der Lage des Werkstücks (12), vorgesehen ist.

6. Flächensauggreifer nach einem der vorhergehenden Ansprüche, **dadurch gekennzeichnet, dass** die Saugwand (18) von einer Lochplatte (22) gebildet wird und/oder auswechselbar an der Saugkammer (16) befestigt ist.

## Claims

1. Pneumatically actuated area vacuum gripper (10) for gripping and, if applicable, separating workpieces (12), in particular of thin, flexible workpieces (12), with a suction chamber (16) attachable on the workpiece (12), comprising a suction wall (18), an ejector nozzle (28) comprising a connection and an outlet (40), wherein the ejector nozzle (28) is connected to the suction chamber (16) via its connection, and the outlet (40) of the ejector nozzle (28) opens to the outside (42) or into an exhaust air duct and the suction inlet (38) of the ejector nozzle (28) situated in the connection empties into the suction chamber (16), wherein the direction of the air stream in the connection coming from the suction chamber (16) corresponds to the direction of the main air conveyance in the ejector nozzle (28), **characterized in that** the suction wall (18) comprises perforations (20), and that the ejector nozzle (28) comprises a sleeve-shaped section (36) with a free end (54), wherein the free end (54) comprises a surface curved or inclined in the direction oft the main air conveyance stream, and the suction chamber (16) comprises an upper side (50), wherein an annular clearance (48) is formed between the free end (54) and the upper side (50) of the suction chamber (16), whereby the propulsion air or utility air enters the ejector nozzle (28) outside the suction chamber (16) and upon entry into the space in the ejector nozzle (28) delimiting the main conveyance air stream follows the curved or inclined surface, wherein the propulsion air or utility air enters the ejector nozzle (28) and the space in the ejector nozzle (28) delimiting the main conveyance air stream via the annular clearance (48), and **in that** the workpiece (12) rests against the suction wall (18) of the suction chamber (16) constituting the bottom side.

2. Area vacuum gripper according to claim 1, **characterized in that** the air stream coming from the suction chamber (16) is not redirected after the connection in the ejector nozzle (28).

3. Area vacuum gripper according to one of the preceding claims, **characterized in that** the surface is formed by a radius rotating about an axis.

4. Area vacuum gripper according to one of the preceding claims, **characterized in that** the outlet opening (26) of the suction chamber (16) is connected to the suction inlet (38) of the ejector nozzle (28) and in particular arranged coaxially to it.

5. Area vacuum gripper according to one of the preceding claims, **characterized in that** in particular in the suction chamber (16) or at the suction space a sensor, e. g. a flow sensor, a vacuum sensor (66) for monitoring the load of the suction wall (18) and/or an optical sensor (68) for monitoring the load and/or determining the position of the workpiece (12) are provided.

6. Area vacuum gripper according to one of the preceding claims, **characterized in that** the suction plate (18) is formed by a perforated plate (22) and/or is fastened in an exchangeable manner to the suction chamber (16).

## Revendications

1. Pince aspirante de surface (10) fonctionnant à l'air comprimé destinée à saisir et éventuellement à séparer des pièces (12), en particulier des pièces minces et flexibles (12), comprenant une chambre d'aspiration (16) pouvant être placée sur la pièce (12) et dotée d'une paroi d'aspiration (18), une buse d'éjection (28) comprenant un raccordement et une sortie (40), la buse d'éjection (28) étant raccordée par son raccordement à la chambre d'aspiration (16) et la sortie (40) de la buse d'éjection (28) débouchant en plein air (42) ou dans une gaine d'air vicié et l'entrée d'aspiration (38) de la buse d'éjection (28) située dans le raccordement débouchant dans la chambre d'aspiration (16), la direction du courant d'air provenant de la chambre d'aspiration (16) dans le raccordement correspondant à la direction du débit d'air principal dans la buse d'éjection (28), **caractérisée en ce que** la paroi d'aspiration (18) comprend des passages (20) et **en ce que** la buse d'éjection (28) comprend une partie en forme de manchon (36) dotée d'une extrémité libre (54), l'extrémité libre (54) comprenant une surface fléchie ou inclinée en direction du débit d'air principal et la chambre d'aspiration (16) comprenant un côté supérieur (50), une fente annulaire (48) étant formée entre l'extrémité libre (54) et le côté supérieur (50) de la chambre d'aspiration (16), ce qui permet à l'air induit ou à l'air de fonctionnement de pénétrer de l'extérieur de la chambre d'aspiration (16) dans la buse d'éjection (28) et, lors de sa pénétration dans l'espace délimitant le débit d'air principal dans la buse d'éjection (28), de suivre la surface fléchie ou inclinée, l'air induit ou l'air de fonctionnement pénétrant dans la buse d'éjection (28) et dans l'espace délimitant le débit d'air principal dans la buse d'injection (28) à travers la fente annulaire (48), et **en ce que** la pièce (12) repose contre la paroi d'aspiration (18) de la chambre d'aspiration (16) formant le côté inférieur.

2. Pince aspirante de surface selon la revendication 1, **caractérisée en ce que** le courant d'air provenant de la chambre d'aspiration (16) n'est pas dévié après le raccordement dans la buse d'éjection (28).

3. Pince aspirante de surface selon l'une quelconque des revendications précédentes, **caractérisée en ce que** la surface est formée par un rayon tournant autour d'un axe.

4. Pince aspirante de surface selon l'une quelconque des revendications précédentes, **caractérisée en ce que** l'ouverture de sortie (26) de la chambre d'aspiration (16) est reliée à l'entrée d'aspiration (38) de la buse d'éjection (28) et en particulier disposée de manière coaxiale par rapport à celle-ci.

5. Pince aspirante de surface selon l'une quelconque des revendications précédentes, **caractérisée en ce qu'**un capteur, par exemple un capteur d'écoulement, un capteur de vide (66) destiné au contrôle de référence de la paroi d'aspiration (18) et/ou un capteur optique (68) destiné au contrôle de référence et/ou à la détermination de la position de la pièce (12) est présent, en particulier dans la chambre d'aspiration (16) ou sur la chambre d'aspiration.

6. Pince aspirante de surface selon l'une quelconque des revendications précédentes, **caractérisée en ce que** la paroi d'aspiration (18) est formée par une plaque perforée (22) et/ou est fixée amovible à la chambre d'aspiration (16).
